# DEMANDE DE BREVET EUROPEEN

(11) **EP 0 902 512 A2**
(43) Date de publication de la demande: **17.03.1999**
(21) Numéro de dépôt: 98402199.8
(22) Date de dépôt: 07.09.1998
(51) Int. Cl.: H01S 3/25, G02F 1/35

(54) **Structure interferométrique integrée**

(30) Priorité: 08.09.1997 FR 9711122
(71) Demandeur: ALCATEL, 75008 Paris (FR)
(72) Inventeur: Dagens, Béatrice, 75014 Paris (FR); Janz, Christopher, 92130 Issy les Moulineaux (FR)
(74) Mandataire: Fournier, Michel Robert Marie

(57) **Abrégé**

L'invention se rapporte à des structures interférométriques intégrées, notamment pour convertisseurs de longueur d'onde de signaux optiques.

Une première et une seconde branche de la structures, comportant au moins un premier amplificateur optique semiconducteur (OA₁), sont couplées à des amplificateurs optiques semi-conducteurs périphériques d'entrée (OA₄, OA₅) et/ou de sortie (OA₃). La structure est caractérisée en ce qu'elle comporte une section d'atténuation (10) entre la sortie d'au moins un amplificateur (OA₁) d'une des branches et l'entrée de l'amplificateur périphérique de sortie (OA₃) et/ou en ce que la longueur du guide d'onde d'au moins un amplificateur périphérique (OA₃, OA₄, OA₅) est inférieure à 300*µ*m.

Utilisation dans le domaine des télécommunications, en particulier pour le routage de signaux.

## Description

L'invention se rapporte à des systèmes optoélectroniques utilisés pour la transmission optique ou le traitement de données numériques optiques.

Elle se rapporte plus particulièrement à des structures interférométriques qui permettent de réaliser des convertisseurs de longueur d'onde et des multiplexeurs d'insertion-extraction utilisés dans le domaine des télécommunications. En particulier, les convertisseurs de longueur d'onde servent à convertir un signal optique transmis, d'une longueur d'onde à une autre longueur d'onde, tout en conservant ses performances.

De tels changements de longueur d'onde sont utilisés en particulier lors du routage des signaux pour résoudre les problèmes de contention.

Dans ces dispositifs, les informations sont sous la forme de données binaires représentées par des impulsions modulant une onde porteuse optique. Une valeur binaire est donc déterminée en fonction du niveau d'amplitude (ou de puissance) de l'onde optique modulée.

Au cours de la transmission, ce signal peut subir des dégradations qui rendent plus difficile, au niveau des récepteurs, la détection des niveaux hauts et bas du signal reçu.

Dans le domaine de l'amplitude, la qualité d'un signal optique est habituellement définie par au moins deux paramètres : le rapport signal à bruit et le taux d'extinction.

Le rapport signal à bruit est défini comme le rapport de la puissance optique du signal à la puissance du bruit dans une bande de longueur d'onde contenant la longueur d'onde de la porteuse du signal.

Le taux d'extinction est défini comme le rapport des puissances correspondant respectivement aux niveaux hauts et bas du signal. Ce taux doit être suffisamment élevé malgré les variations du signal d'entrée.

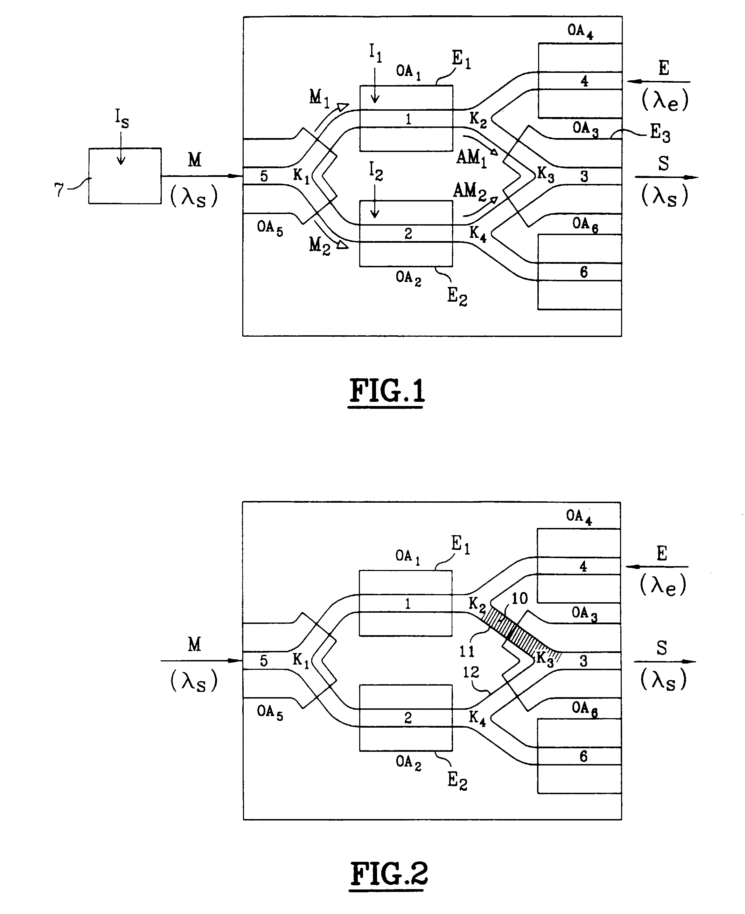

Une structure interférométrique est représentée sur la figure 1 dans le cas du convertisseur de longueur d'onde. Elle est constituée de deux branches guidantes 1 et 2. Au moins une de ces branches est munie d'un amplificateur optique semi-conducteur OA₁. Cependant, en général on préfère placer un deuxième amplificateur optique semi-conducteur OA₂ sur l'autre branche 2 pour des raisons de symétrie. En effet, la présence du deuxième amplificateur optique semi-conducteur OA₂ permet de conserver sensiblement le même niveau d'amplification dans les deux branches de la structure et par conséquent d'avoir des puissances sensiblement identiques en sortie des branches de l'interféromètre.

Ces deux amplificateurs optiques OA₁, OA₂ suffisent à former la structure interférométrique lorsque celle-ci est de type "actif-passif", c'est à dire lorsque les guides qui la composent sont réalisés à partir de deux types de matériaux, pour former des guides actifs et des guides passifs. Dans ce cas en effet, les guides situés aux extrémités de la structure interférométrique forment des guides passifs et sont réalisés dans un matériau non absorbant si bien que le signal optique en sortie de la structure interférométrique est identique au signal issu des amplificateurs OA₁ et OA₂. Cependant, la réalisation d'une telle structure intégrée de type "actif-passif" est très compliquée à mettre en oeuvre car elle nécessite plusieurs reprises d'épitaxie successives pour déposer les deux types de matériaux. La réalisation de cette structure étant longue et fastidieuse, son coût s'en trouve considérablement augmenté.

Pour simplifier la fabrication et diminuer le coût d'une telle structure interférométrique intégrée, on préfère donc réaliser une structure dite "toute active", c'est-à-dire une structure dont les guides sont tous actifs et formés dans un seul matériau. Cependant, dans ce cas le signal optique issu des amplificateurs OA₁ et OA₂ est fortement absorbé par le matériau utilisé et la puissance optique en sortie de la structure devient beaucoup trop faible pour être détectée. Par conséquent, dans une telle structure de type "tout actif", il est nécessaire de placer des amplificateurs optiques périphériques afin d'amplifier la puissance optique absorbée et de récupérer un signal convenable en sortie de la structure. Ces amplificateurs périphériques sont référencés OA₃, OA₄, OA₅ et OA₆ sur la figure 1.

Les éléments constitutifs de la structure interférométrique de type "tout actif" représentée sur la figure 1 sont détaillés ci-dessous.

Un premier coupleur K₁ permet de coupler une extrémité de chacune de ces branches à un amplificateur optique semi-conducteur périphérique, encore dénommé amplificateur d'entrée OA₅. Une source laser 7 permet par ailleurs de fournir, à cet amplificateur périphérique OA₅, une onde porteuse de sortie M de longueur d'onde λS.

Un second coupleur K₂ est disposé de façon à coupler l'autre extrémité de la première branche 1 à un autre amplificateur optique semi-conducteur périphérique d'entrée OA₄. Ce coupleur K₂ permet l'introduction, dans le premier amplificateur OA₁ d'un signal d'entrée E de longueur d'onde λe ayant été amplifié par l'amplificateur d'entrée OA₄. L'amplificateur OA₁ sature et l'état de l'interféromètre est changé, ce qui entraîne une modulation de phase de l'onde porteuse de sortie.

Un troisième coupleur K₃ relié au coupleur K₂, au deuxième amplificateur OA₂, et à un autre amplificateur optique semi-conducteur périphérique OA₃, dit de sortie, est disposé de façon à fournir un signal de sortie S résultant du couplage d'ondes auxiliaires AM₁ et AM₂ fournies respectivement par les premier et deuxième amplificateurs OA₁ et OA₂. Les ondes AM₁ et AM₂ correspondent aux ondes M₁ et M₂ issues du coupleur K₁ et amplifiées respectivement par les amplificateurs OA₁ et OA₂. Le signal de sortie S, de longueur d'onde λs, est ensuite amplifié par l'amplificateur périphérique de sortie OA₃.

Un autre amplificateur périphérique OA₆ est par ailleurs prévu pour respecter la symétrie de la structure et pour permettre le remplacement de l'un des amplificateurs OA₃ ou OA₄ dans le cas d'une éventuelle panne.

Des courants I1 et I2 sont injectés respectivement dans les amplificateurs OA₁ et OA₂, au travers d'électrodes E1 et E2. Le signal de sortie S résulte d'une interférence constructive ou destructrice des ondes AM₁ et AM₂, selon la différence de phase entre les deux branches de l'interféromètre.

Pour assurer une conversion de longueur d'onde efficace, le seuil de puissance de saturation des amplificateurs OA₁ et OA₂ situés dans les branches 1 et 2 d'une telle structure interférométrique est fixé relativement bas. Par conséquent, lorsque l'interférence des ondes AM₁ et AM₂ est constructive, c'est à dire lorsque les ondes AM₁ et AM₂ sont en phase, les puissances optiques des deux amplificateurs OA₁ et OA₂ s'ajoutent si bien que la puissance optique dans l'amplificateur de sortie OA₃ est très élevée.

Dans ce cas, l'amplificateur de sortie OA₃ sature fortement et le taux d'extinction s'en trouve très dégradé. En effet, le gain des niveaux hauts devient inférieur au gain des niveaux bas, si bien que le signal de sortie S subit une compression des niveaux hauts et se trouve par conséquent déformé. Cette déformation peut également se produire sur le signal d'entrée E, ou sur l'onde porteuse de sortie M. Or, si le signal d'entrée E est déformé, ou si l'onde porteuse de sortie M est déformée, alors le signal de sortie S est également dégradé et le taux d'extinction de la structure interférométrique est amoindri.

Il apparaît donc souhaitable que les amplificateurs périphériques puissent fonctionner en régime non saturé.

De manière générale, la puissance de saturation d'entrée d'un amplificateur est définie par la puissance optique d'entrée pour laquelle le gain de l'amplificateur est divisé par 2.

Les inconvénients précités peuvent apparaître dans toute structure interférométrique "toute active". L'invention a pour but de remédier à ces inconvénients en proposant une structure qui, par rapport aux structures connues, rend la puissance de saturation d'entrée des amplificateurs périphériques plus difficile à atteindre par la puissance d'entrée de ces amplificateurs. Pour cela, on peut soit chercher à augmenter la puissance de saturation d'entrée desdits amplificateurs soit faire de telle sorte que la puissance d'entrée de ces amplificateurs soit réduite. Elle a plus précisément pour objet une structure interférométrique intégrée pour fournir un signal optique de sortie, dans laquelle une première et une seconde branche, comportant au moins un premier amplificateur optique semi-conducteur, sont couplées à des amplificateurs optiques semi-conducteurs périphériques d'entrée et/ou de sortie, caractérisée en ce que ladite structure comporte une section d'atténuation entre la sortie d'au moins un amplificateur optique semi-conducteur d'une des branches et l'entrée de l'amplificateur périphérique de sortie et/ou la longueur du guide d'onde d'au moins un amplificateur périphérique est inférieure à 300 µm.

Selon une autre caractéristique de l'invention, la section d'atténuation apporte au moins 50% de pertes optiques.

D'autres particularités et avantages de l'invention apparaîtront à la lecture de la description donnée, dans le cas particulier du convertisseur de longueur, d'onde à titre d'exemple illustratif mais non limitatif, et faite en référence aux figures annexées qui représentent :
- la figure 1, déjà décrite, un schéma d'une structure interférométrique de type Mach-Zehnder connue à amplificateurs optiques semi-conducteurs périphériques,
- la figure 2, un schéma d'un convertisseur de longueur d'onde selon un premier mode de réalisation,
- les figures 3A à 3C, des courbes de variation, respectivement de la puissance de sortie (Ps), du taux d'extinction (TE) et du rapport signal à bruit (S/B) en fonction du courant (I) injecté et du taux de transmission optique dans un amplificateur périphérique,
- la figure 4, un schéma d'un convertisseur de longueur d'onde selon un autre mode de réalisation,
- les figures 5A à 5C, des courbes de variation, respectivement de la puissance de sortie (Ps), du taux d'extinction (TE) et du rapport signal à bruit (S/B) en fonction du courant (I) injecté et de la longueur du guide d'onde d'un amplificateur périphérique,
- la figure 6, un schéma d'une structure de type Michelson à laquelle s'applique l'invention,
- la figure 7, un schéma d'une structure de type multiplexeur interférométrique d'insertion-extraction.

Dans tout le reste de la description, les mêmes références sont utilisées pour désigner les mêmes éléments.

Pour pouvoir effectuer des conversions de longueur d'onde efficaces, les amplificateurs optiques semi-conducteurs OA₁ et OA₂ situés sur les branches des interféromètres de type Mach-Zehnder ou équivalent doivent présenter un seuil de saturation relativement bas.

Au contraire, pour que le taux d'extinction soit optimum en sortie de l'interféromètre et pour éviter que le signal d'entrée E et l'onde porteuse de sortie M ne soient eux aussi déformés, il convient que les amplificateurs périphériques OA₃, OA₄ et OA₅ fonctionnent en régime aussi peu saturé que possible. Pour cela, la structure doit être telle que le seuil de saturation d'entrée soit plus difficilement atteint par la puissance d'entrée.

Pour obtenir une telle structure, on peut soit réduire la puissance optique injectée dans cet amplificateur ou alors augmenter son seuil de saturation.

Pour éviter une dégradation du taux d'extinction en sortie de l'interféromètre, on modifie les conditions de fonctionnement d'au moins un amplificateur périphérique. Ces conditions de fonctionnement sont notamment la puissance optique à l'entrée de l'amplificateur ou encore sa puissance de saturation d'entrée. De préférence, ce sont les conditions de fonctionnement de l'amplificateur de sortie qui sont prioritairement modifiées. Les conditions de fonctionnement des autres amplificateurs périphériques OA₄ puis OA₅ peuvent ensuite être modifiées pour éviter toute déformation du signal d'entrée E de l'onde porteuse de sortie M.

Un premier mode de réalisation d'un convertisseur de longueur d'onde selon l'invention consiste à permettre une réduction de la puissance optique injectée dans l'amplificateur périphérique de sortie OA₃. Ce premier mode de réalisation est illustré sur le schéma de la figure 2 qui représente un convertisseur de longueur d'onde comportant une structure interférométrique de type Mach-Zehnder.

De manière avantageuse ce convertisseur comporte une section d'atténuation 10, représentée en traits hachurés sur la figure 2, située entre la sortie de l'amplificateur optique OA₁ de la première branche 1 et l'entrée de l'amplificateur périphérique de sortie OA₃.

De manière générale, la position de l'entrée de l'amplificateur de sortie OA₃ est définie comme étant située juste derrière le coupleur K₃ et non à la limite de l'électrode E₃.

La section d'atténuation 10 est obtenue en introduisant des pertes optiques dans le bras correspondant 11 de guide d'onde.

Pour cela, le bras 11 de guide d'onde peut par exemple être interrompu afin de diffracter une partie de la lumière. Dans ce cas, le guide possède par exemple deux sections effilées en regard l'une de l'autre, ce qui permet de diffracter une partie de la puissance lumineuse et d'en réinjecter une autre partie. Ce cas est le plus simple à réaliser car seule la forme du masque utilisé pour réaliser la gravure du guide d'onde change.

Une autre méthode pour introduire ces pertes consiste par exemple à courber le bras 11 du guide, par rapport à l'extrémité de l'amplificateur OA₁, selon une pente plus importante.

Les pertes peuvent également être introduites seulement au niveau du coupleur K₃ en utilisant par exemple un coupleur mal adapté à la structure interférométrique.

Bien sûr ces méthodes ne sont que des exemples. En fait toutes les méthodes connues qui permettent d'introduire des pertes optiques dans la section 10 du convertisseur peuvent être utilisées.

Dans une variante de réalisation, la section d'atténuation peut en outre être réalisée entre la sortie des deux amplificateurs OA₁, OA₂ et l'entrée de l'amplificateur de sortie OA₃, le long des bras 11 et 12 de guide d'onde.

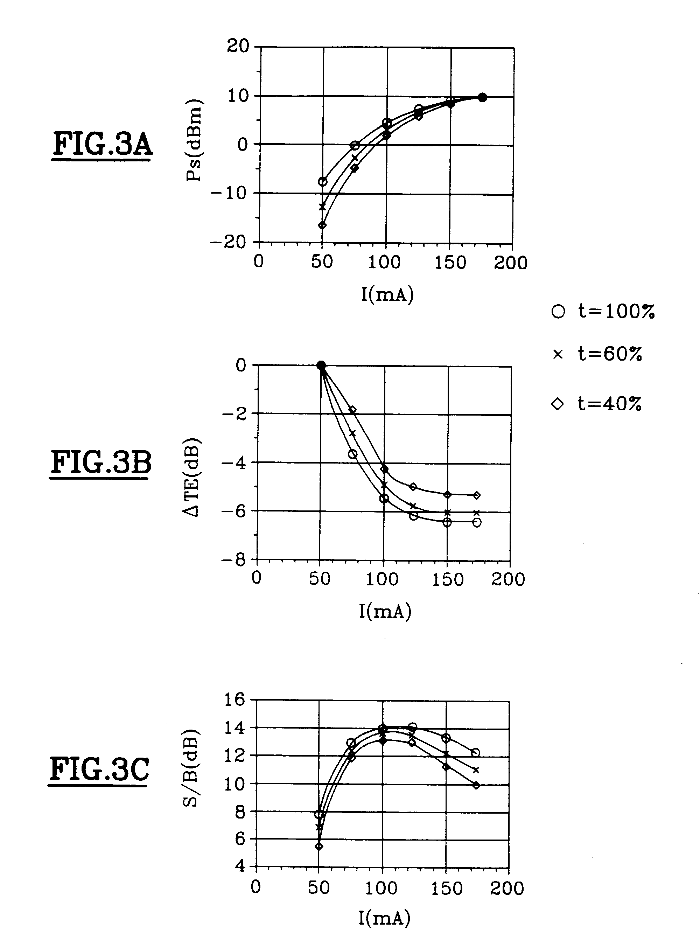

Les courbes des figures 3A à 3C permettent de comparer les résultats obtenus à partir d'un convertisseur de longueur d'onde comportant une section d'atténuation, entre les amplificateurs OA₁ et OA₂ et l'amplificateur OA₃, apportant respectivement:
- aucune perte optique (Puissance optique totale dans l'amplificateur OA₃ Pt=200%=somme des puissances de sortie des amplificateurs OA₁ et OA₂ ; et taux de transmission optique de chaque bras 11 et 12 t= 100%),
- 80% de pertes optiques ( Puissance optique totale Pt=120% et taux de transmission de chaque bras 11 et 12 t=60%), et
- 120% de pertes optiques (Puissance optique totale Pt=80% et taux de transmission de chaque bras 11 et 12 t=40%).

Le but à atteindre est d'obtenir un niveau de puissance de sortie Ps du convertisseur constant sans détériorer le taux d'extinction TE ni le rapport signal à bruit S/B.

Ces courbes indiquent que, pour une même puissance de sortie Ps, le taux d'extinction TE augmente avec la diminution de la transmission, c'est à dire avec l'augmentation du coefficient d'atténuation dans les bras 11 et 12. Le rapport signal à bruit S/B, quant à lui, reste sensiblement équivalent.

Par conséquent il est préférable d'atténuer fortement la puissance optique en sortie des amplificateurs OA₁ et/ou OA₂ pour maintenir un taux d'extinction optimum en sortie du convertisseur et éviter la déformation du signal. Ainsi, la structure de la section d'atténuation est telle qu'elle permet un apport d'au moins 50% de pertes optiques.

De préférence, la section d'atténuation 10 dans les bras 11 et 12, située entre la sortie des l'amplificateurs OA₁ et OA₂ respectivement et l'entrée de l'amplificateur de sortie OA₃, apporte au moins 50% de pertes optiques dans chaque bras 11 et 12 pour permettre de réduire d'un facteur 2 la puissance optique totale dans le coupleur K₃, c'est à dire la puissance injectée dans l'amplificateur de sortie OA₃.

Un deuxième mode de réalisation d'un convertisseur de longueur d'onde selon l'invention consiste à augmenter le seuil de saturation d'au moins un amplificateur périphérique. Pour cela, la structure du guide d'onde actif de cet amplificateur périphérique est modifiée.

De préférence, c'est la structure du guide de l'amplificateur de sortie OA₃ qui est prioritairement modifiée pour maintenir un bon taux d'extinction du signal de sortie S, et éviter ainsi toute déformation de ce signal. La structure des autres amplificateurs périphériques d'entrée OA₄ puis OA₅ peut ensuite être modifiée afin d'éviter toute déformation du signal d'entrée E et de l'onde porteuse de sortie M.

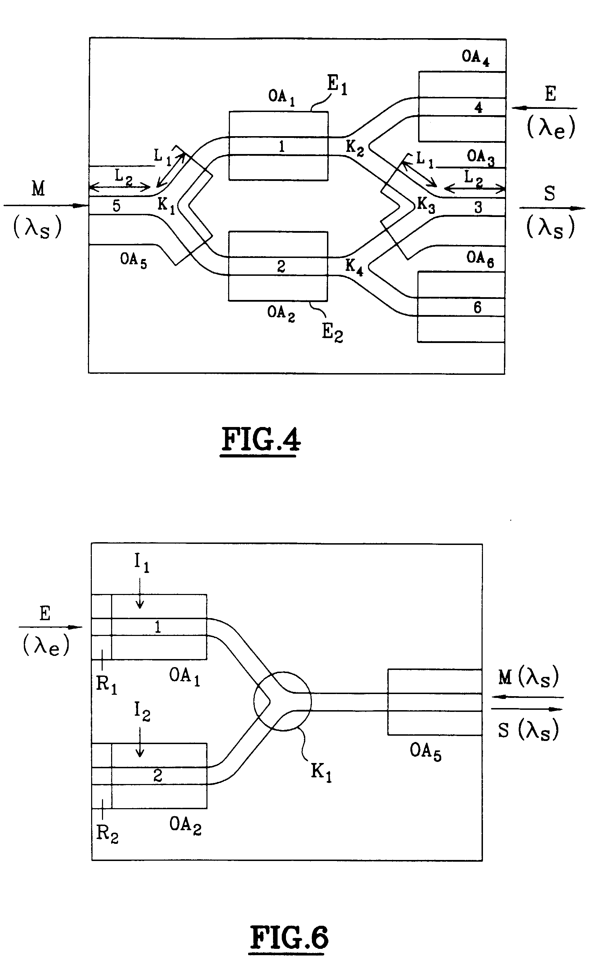

Le deuxième mode de réalisation est illustré sur le schéma de la figure 4 qui représente un convertisseur de longueur d'onde comportant une structure interférométrique de type Mach-Zehnder dans lequel la longueur des guides actifs des amplificateurs périphériques de sortie OA₃ et d'entrée OA₄ et OA₅ est inférieure à une valeur limite déterminée.

La puissance de saturation d'entrée d'un amplificateur optique semi-conducteur varie inversement à la longueur du guide actif de cet amplificateur. Par conséquent, pour augmenter la puissance de saturation des amplificateurs périphériques, et notamment celle de l'amplificateur de sortie OA₃, la longueur de leur guide actif est restreinte.

La dégradation du taux d'extinction se produit essentiellement dans l'amplificateur de sortie OA₃, après le coupleur K₃, mais aussi à la sortie des amplificateurs d'entrée OA₄ et OA₅, avant les coupleurs K₂ et K₁. Cette dégradation du taux d'extinction augmente avec la longueur du guide d'onde actif de ces amplificateurs car la puissance de saturation associée diminue.

De manière générale, on définit la longueur du guide actif d'un amplificateur périphérique comme étant la longueur L2 de la portion de guide située aux extrémités du convertisseur, c'est à dire entre un coupleur K₃ ou K₁ et la sortie ou l'entrée de la structure interférométrique.

La longueur L1 de la première portion du guide actif, de l'amplificateur de sortie OA₃, qui est située avant la jonction Y, c'est à dire avant le coupleur K₃, est moins importante. En effet, dans cette portion de guide, le signal converti AM₁ n'a pas encore interféré avec le signal AM₂ fournit par le deuxième amplificateur OA₂ de l'interféromètre et est encore modulé en phase : la saturation de l'amplificateur de sortie OA₃ ne modifie donc pas, dans cette portion de guide, le taux d'extinction du signal. Par conséquent la longueur L1 de la portion de guide précédant le coupleur K₃ n'est pas restreinte.

En revanche, si la longueur à prendre effectivement en compte, c'est à dire la longueur L2 de la deuxième portion du guide actif située après le coupleur K₃, est supérieure à une valeur limite déterminée, alors la puissance de saturation de l'amplificateur de sortie OA₃ devient trop faible pour permettre à l'interféromètre de fonctionner à une puissance de sortie Ps convenable et avec un rapport signal à bruit S/B et un taux d'extinction TE non dégradés. Cette valeur limite de la longueur L2 du guide de l'amplificateur périphérique est égale à 300 µm.

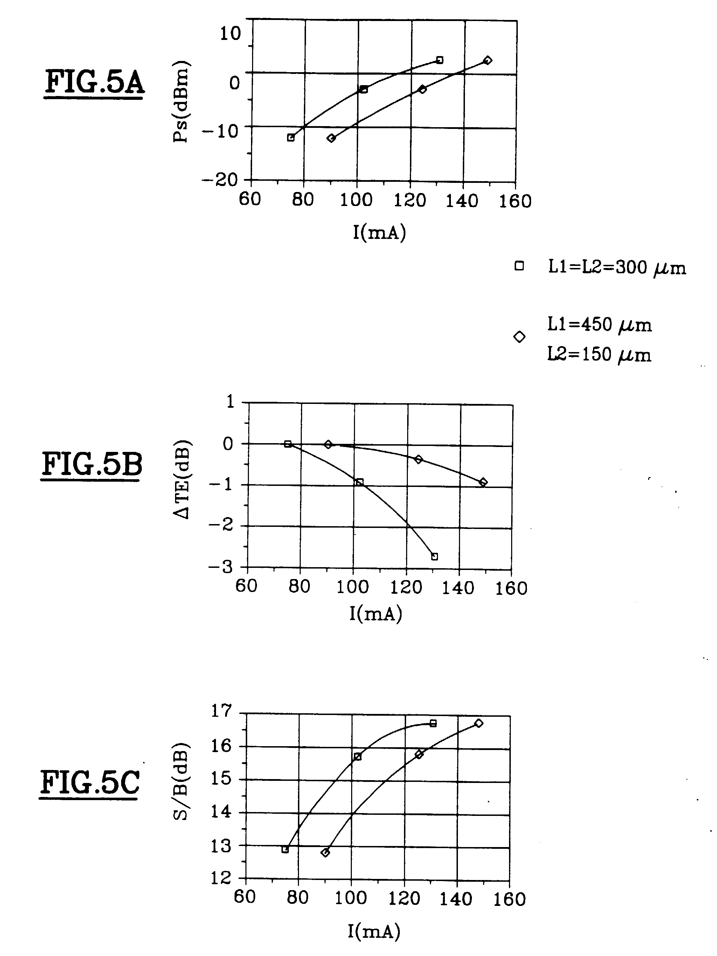

Les courbes des figures 5A à 5C permettent de comparer les résultats obtenus à partir d'un amplificateur périphérique, par exemple l'amplificateur de sortie OA₃, dans lequel la longueur L2 du ruban de couche active est respectivement égale et inférieure à 300 µm.

Cependant, dans les deux cas, la longueur globale L de l'amplificateur comparé reste identique. En effet, dans les deux cas, la somme de la longueur L2 de la portion de guide située après le coupleur K₃ et de la longueur L1 de la portion de guide située avant ce coupleur est identique et égale, dans l'exemple illustré sur les figures 5A à 5C, à 600 µm.

Ces courbes indiquent que, pour une même puissance de sortie Ps et pour un rapport signal à bruit S/B équivalent, on obtient une dégradation du taux d'extinction beaucoup plus faible lorsque la longueur du guide est inférieure à 300 µm.

Ainsi, pour une puissance de sortie supérieure à -5 dBm, la dégradation du taux d'extinction TE est supérieure à 1 voire 2 dB lorsque la longueur de l'amplificateur est de 300µm, alors qu'elle reste strictement inférieure à 1dB lorsque la longueur de l'amplificateur est égale à 150 µm.

Par conséquent, la longueur du guide d'onde actif d'au moins un amplificateur périphérique est de préférence inférieure à 300µm afin d'augmenter le seuil de saturation de cet amplificateur et de maintenir un taux d'extinction optimum tout en conservant une puissance de sortie Ps convenable.

La longueur du guide d'onde actif doit cependant être à la fois suffisamment longue pour permettre une filtration des modes optiques d'ordres élevés et un fonctionnement de bonne qualité de l'interféromètre, et suffisamment courte pour éviter les effets de saturation du signal. Par conséquent, cette longueur est de préférence comprise entre 100 et 300µm.

Les modes de réalisation qui viennent d'être décrits sont très simples à mettre en oeuvre puisqu'ils ne nécessitent pas d'étape de technologie supplémentaire au cours de la fabrication des composants optiques. Dans la réalisation la plus simple, seule la forme du masque utilisé pour réaliser la gravure des guides d'onde actifs change.

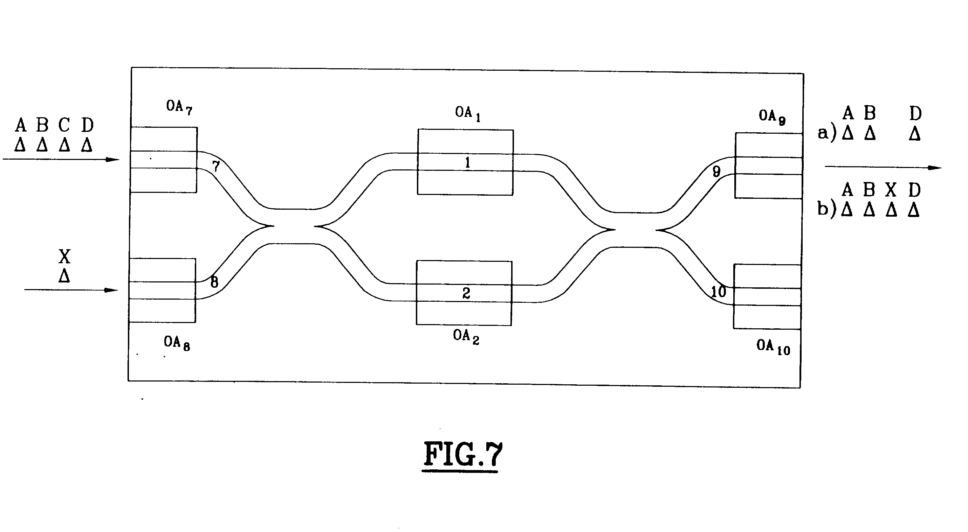

La figure 6 représente une autre structure de type Michelson équivalente à la précédente à laquelle s'applique l'invention. Selon cette variante, les deux amplificateurs OA₁ et OA₂ sont couplés par une seule de leurs extrémités, les faces opposées étant munies d'un revêtement réfléchissant R1, R2. Le signal d'entrée modulant E est injecté dans le premier amplificateur OA₁ par l'intermédiaire de la face R1 et l'onde porteuse de sortie M est injectée dans les deux amplificateurs OA₁ et OA₂ par les faces opposées aux faces R1 et R2, par l'intermédiaire d'un coupleur K1 permettant de coupler une extrémité de chacune des branches 1 et 2 à un amplificateur optique semi-conducteur périphérique OA₅. Un signal de sortie S, de longueur d'onde λ_{S}, résultant du couplage d'ondes auxiliaires fournies par les premier et deuxième amplificateurs OA₁ et OA₂, est ensuite amplifié par l'amplificateur périphérique OA₅.

La figure 7 représente un autre type de structure interférométrique à laquelle s'applique l'invention. Ce type de structure concerne les multiplexeurs interférométriques d'insertion-extraction. La structure représentée sur la figure 7 correspond à un dispositif "tout actif" et comprend des amplificateurs périphériques OA₇, OA₈, OA₉, OA₁₀ à ses extrémités. Un signal multiplexé à 4 canaux ABCD par exemple est injecté dans l'amplificateur référencé OA₇. Ce signal est séparé en deux dans les branches 1 et 2 de l'interféromètre puis recomposé et récupéré à la sortie de l'amplificateur OA₉. L'un des canaux du signal, par exemple le canal C, peut être supprimé en envoyant une impulsion de contrôle par l'amplificateur OA₉ pour déphaser les impulsions du canal C en question. Le signal récupéré à la sortie de l'amplificateur OA₉ correspond alors au cas référencé a) sur la figure 7 et ne comprend plus que 3 canaux ABD. De la même façon, on peut ensuite ajouter un autre canal X par l'amplificateur OA₈. Dans ce cas, référencé b) sur la figure 7, on récupère à la sortie de l'amplificateur OA₉ un signal multiplexé comprenant 4 canaux ABXD.

## Revendications

1. Structure interférométrique intégrée pour fournir un signal optique de sortie (S), dans laquelle une première et une seconde branche, comportant au moins un premier amplificateur optique semi-conducteur (OA₁), sont couplées à des amplificateurs optiques semi-conducteurs périphériques d'entrée (OA₄, OA₅) et/ou de sortie (OA₃), caractérisée en ce que ladite structure comporte une section d'atténuation (10) entre la sortie d'au moins un amplificateur (OA₁) d'une des branches et l'entrée de l'amplificateur périphérique de sortie (OA₃) et/ou la longueur (L2) du guide d'onde d'au moins un amplificateur périphérique est inférieure à 300µm.

2. Structure interférométrique selon la revendication 1, caractérisée en ce que la section d'atténuation (10) apporte au moins 50% de pertes optiques.

3. Structure interférométrique selon la revendication 1, caractérisée en ce que la longueur (L2) du guide d'onde est de préférence comprise entre 100 µm et 300 µm.

4. Convertisseur de longueur d'onde, caractérisé en ce qu'il comporte une structure interférométrique intégrée selon l'une des revendications 1 à 3.

5. Multiplexeur d'insertion-extraction, caractérisé en ce qu'il comporte une structure interférométrique intégrée selon l'une des revendications 1 à 3.
